(19) Europäisches Patentamt
European Patent Office
Office européen des brevets

(11) **EP 1 460 442 A2**

(12) **EUROPEAN PATENT APPLICATION**

(43) Date of publication:
**22.09.2004 Bulletin 2004/39**

(51) Int Cl.$^7$: **G01R 33/09**

(21) Application number: **04250844.0**

(22) Date of filing: **17.02.2004**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **18.03.2003 US 391137**

(71) Applicant: **Hewlett-Packard Development Company, L.P.**
**Houston, TX 77070 (US)**

(72) Inventor: **Sharma, Manish**
**Mountain View, California 94043 (US)**

(74) Representative: **Powell, Stephen David et al**
**WILLIAMS POWELL**
**Morley House**
**26-30 Holborn Viaduct**
**London EC1A 2BP (GB)**

(54) **A magnetic sensor**

(57) A magnetic apparatus (300) includes a pinning layer (310) and ferromagnetic layers (322, 324, 326), at least one of the ferromagnetic layers being adjacent to the pinning layer (310). A spacer layer 9340) is adjacent to at least one other of the ferromagnetic layers. A sense layer (330) is adjacent to the spacer layer (340). The thickness of each of the ferromagnetic layers (322, 324, 326) is formed so that a Ne'el magnetic field between the sense layer (330) and the ferromagnetic layers (322, 324, 326) is in an opposite direction to a demagnetizing field between the ferromagnetic layers (322, 324, 326) and the sense layer (330).

FIGURE 3

**EP 1 460 442 A2**

**Description**

The invention relates generally to sensing magnetic fields. More particularly, the invention relates to an apparatus, system and method that minimizes switching offset in magnetic field sensors.

Magnetic field detection can be used for sensing information stored on a surface of a magnetic medium, such as, a magnetic disk or tape. The magnetic sensor must be physically located proximate to the magnetic medium to allow detection of the magnetically stored information.

Magnetic sensors can also be used in magnetic memory. For example, magnetic random access memory (MRAM) can be used to store information.

A device that can be used to detect the presence of a magnetic field is a magnetic tunnel junction sensor. A magnetic tunnel junction sensor based on tunneling magnetoresistive devices can include spin dependent tunneling junctions. A typical spin dependent junction includes a pinned layer, a sense layer and an insulating tunnel barrier sandwiched between the pinned and sense layers. The pinned layer has a magnetization orientation that is fixed so as not to rotate in the presence of an applied magnetic field in a range of interest. The sense layer has a magnetization that can be oriented in either one of two directions. If the magnetizations of the pinned layer and the sense layer are in the same direction, the orientation of the spin-dependent tunnel junction is said to be parallel. If the magnetizations of the pinned layer and the sense layer are in opposite directions, the orientation of the spin-dependent tunnel junction is said to be anti-parallel. The two stable orientations, parallel and anti-parallel, may correspond to logic values of "0" and "1".

The magnetic orientation of the sense layer is generally aligned in a direction corresponding to a direction of the last external magnetic field that sense layer in the vicinity of the sense layer. The external magnetic field must have enough magnetic strength to alter the orientation of the sense layer in order for the magnetic field to be detected.

A resistance across the magnetic tunnel junction sensor will vary in magnitude depending upon the magnetic orientation of the sense layer with respect to the magnetic orientation of the pinned layer. Typically, if the sense layer has a magnetic orientation that is in the opposite direction as the pinned layer, then the resistance across the magnetic tunnel junction sensor will be large. If the sense layer has a magnetic orientation that is in the same direction as the pinned layer, then the resistance across the magnetic tunnel junction sensor will be less. Therefore, the resistance across the magnetic tunnel junction sensor can be used to sense the direction of a magnetic because the direction of the magnetic field determines the magnetic orientation of the sense layer with respect to the pinned layer, and therefore, the resistance across the magnetic sensor.

Magnetic tunnel junction sensors generally include a switching offset. That is, the magnitude of the magnetic field intensity required to switch the magnetic tunnel junction sensors from a first state to a second state, is generally different than the magnitude of the magnetic field intensity required to switch the magnetic tunnel junction sensors from the second state to the first state. The switching offset can be caused by demagnetizing field and by Ne'el or orange peel coupling. In many different applications of magnetic sensors, a switching offset is undesirable.

It is desirable to have an apparatus and method for sensing magnetic fields that provides less switching offset than existing magnetic field sensor, is non-volatile and dissipates low power.

The invention includes an apparatus and method of sensing magnetic fields that provides improved switching offset, is non-volatile and dissipates low power.

An embodiment of the invention includes a magnetic apparatus. The magnetic apparatus includes a pinning layer. The embodiment further includes a plurality of ferromagnetic layers, at least one of the ferromagnetic layers being adjacent to the pinning layer. A spacer layer is adjacent to at least one other of the ferromagnetic layers. A sense layer is adjacent to the tunnel barrier layer. The magnetic apparatus includes a thickness of each of the ferromagnetic layers being formed so that a Ne'el magnetic field between the sense layer and the ferromagnetic layers is in an opposite direction as a demagnetizing field between the ferromagnetic layers and the sense layer.

Other aspects and advantages of the present invention will become apparent from the following detailed description, taken in conjunction with the accompanying drawings, illustrating by way of example the principles of the invention.

Figure 1 shows a magnetic tunnel junction sensor.

Figure 2 shows a switching response curve of a magnetic tunnel junction sensor.

Figure 3 shows a magnetic tunnel junction sensor according to an embodiment of the invention.

Figure 4 shows a magnetic tunnel junction sensor according to another embodiment of the invention.

Figure 5 shows a switching response curve of a magnetic tunnel junction sensor according to an embodiment of the invention.

Figure 6 shows an array of MRAM memory cells according to an embodiment of the invention.

Figure 7 shows a computing system that includes an array of MRAM memory cells according to an embodiment of the invention.

Figure 8 shows an array of magnetic sensors according to an embodiment of the invention.

Figure 9 shows a disk drive that includes a read head that includes a magnetic sensor according to an embodiment of the invention.

As shown in the drawings for purposes of illustration, the invention is embodied in an apparatus, system and method of sensing magnetic fields that provides improved sensitivity, is non-volatile and dissipates low power.

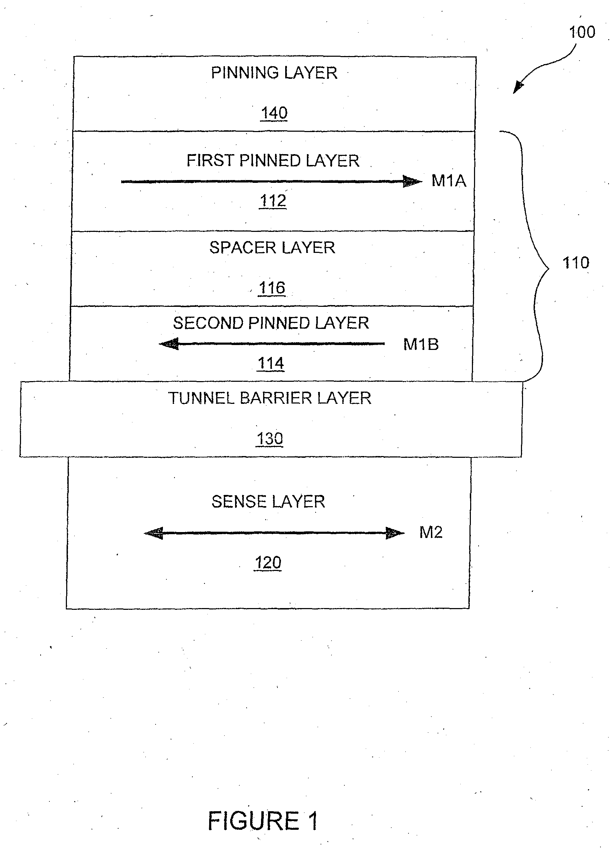

Figure 1 shows an embodiment of a magnetic tunnel junction sensor 100 that includes a synthetic ferrimagnetic reference layer 110 (pinned layer). The synthetic ferrimagnetic reference layer 110 is an improvement over the previously described pinned layer because the synthetic ferrimagnetic reference layer 110 can be configured to minimize a demagnetization field of the magnetic tunnel junction sensor 100.

The magnetic tunnel junction sensor 100 includes the pinned layer (synthetic ferrimagnetic reference layer) 110, a sense layer 120 and an insulating layer 130.

The pinned layer 110 has a net magnetization orientation that is fixed, and will not rotate in the presence of an applied magnetic field in a range of interest. The pinned layer 110 includes a first pinned layer 112 and a second pinned layer 114. A spacer layer 116 is located between the first pinned layer 112 and the second pinned layer 114. The first pinned layer 112 includes a magnetization M1A, and the second pinned layer 114 includes a magnetization M1B. The net magnetization of the pinned layer 110 can generally be represented by the sum of magnetization vectors M1A and M1B. As shown in Figure 1, the magnetization M1A of the first layer 112 is in an opposite direction as the magnetization M1B of the second layer 114. Therefore, their moments tend to cancel each other. However, generally, one of the magnetization vectors is larger than the other, and the reference layer has a net magnetic moment.

A pinning layer 140 aids the pinning of the pinned layer 110. An antiferromagnetic pinning layer 140 can fix the magnetic orientation of the pinned layer 110. The antiferromagnetic pinning layer provides a large exchange field, which holds the magnetization of the pinned layer in one direction. This top-pinned structure includes the underlying pinned layers 110 (that are all above the barrier layer) serving as the seed layers for the antiferromagnetic pinning layer 140.

The sense layer 120 has a magnetization M2 that can be oriented in either of two directions. A first magnetization orientation of the sense layer 120 is in the same direction as the fixed magnetization of the pinned layer 110. A second magnetization orientation of the sense layer 120 is in the opposite direction as the fixed magnetization of the pinned layer 110.

The magnetic orientation of the sense layer 120 is generally aligned in a direction corresponding to a direction of the last external magnetic field that sense layer 120 in the vicinity of the sense layer 120. The external magnetic field must have enough magnetic strength to alter the orientation of the sense layer 120 in order for the magnetic field to be detected.

A resistance across the magnetic tunnel junction sensor 100 will vary in magnitude depending upon the magnetic orientation of the sense layer 120 with respect to the magnetic orientation of the pinned layer 110. Typically, if the sense layer 120 has a magnetic orientation that is in the opposite direction as the pinned layer 110, then the resistance across the magnetic tunnel junction sensor 100 will be large. If the sense layer 120 has a magnetic orientation that is in the same direction as the pinned layer 110, then the resistance across the magnetic tunnel junction sensor 100 will be less. Therefore, the resistance across the magnetic tunnel junction sensor 100 can be used to sense the direction of a magnetic field because the direction of the magnetic field determines the magnetic orientation of the sense layer 120 with respect to the pinned layer 110, and therefore, the resistance across the magnetic sensor 100.

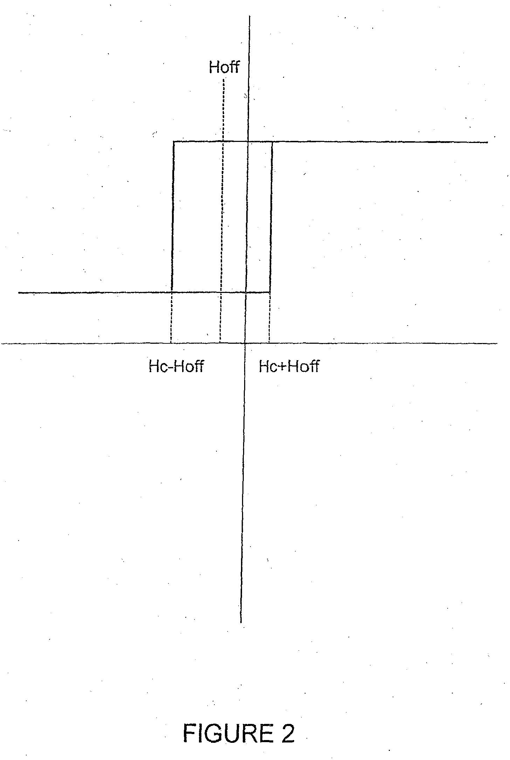

Figure 2 shows a switching response curve of a magnetic tunnel junction sensor. The curve depicts the magnetic field intensity required to switch the logical state of a magnetic tunnel junction from one state to another. For example, the logical state may be changed from a 0 state to a 1 state when a positive field above a threshold Hc is applied. The logical state may be changed from the I state to the 0 state when a negative field threshold -Hc is applied. As shown in Figure 2, the positive field threshold Hc and the negative field threshold -Hc can both include an offset Hoff. Due to the presence of the offset Hoff, a greater magnetic field intensity is required to switch the magnetic tunnel junction to one state that to switch the magnetic tunnel junction to the other state. The offset Hoff is undesirable because the noise margin in one switching direction is smaller than the noise margin in the other switching direction. Additionally, in an array of magnetic tunnel junctions, the offset Hoff can vary from one tunnel junction to another. This is undesirable because not only are the noise thresholds for each direction of each magnetic tunnel junction different, but they are different from one magnetic tunnel junction to another.

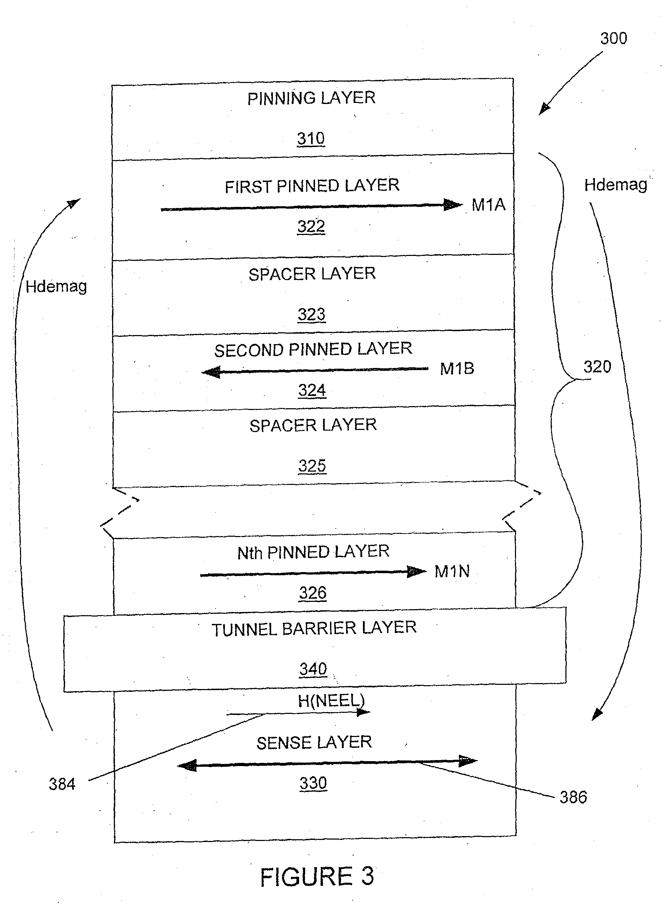

Figure 3 shows an embodiment of the invention. This embodiment includes a magnetic apparatus 300 that can be a magnetic sensor or a magnetic memory cell. This embodiment includes a pinning layer 310. This embodiment further includes a plurality of ferromagnetic pinned layers 322, 324, 326 that form a pinned layer 320. At least one of the ferromagnetic pinned layers 322 is adjacent to the pinning layer 310. A tunnel barrier layer 340 is adjacent to at least one other of the ferromagnetic pinned layers 326. A sense layer 330 is located adjacent to the tunnel barrier layer 340. A thickness of each of the ferromagnetic pinned layers 322, 324, 326 is formed so that a Ne'el magnetic field 384 between the sense layer 380 and the ferromagnetic pinned layers 322, 324, 326 is in an opposite direction as a demagnetizing field (Hdemag) between the ferromagnetic pinning layers 322, 324, 326 and the sense layer 380.

## SWITCHING OFFSET

As previously described, switching offset is undesirable in magnetic tunnel junction sensors and memory cells because the switching offset causes the magnetic device to switch magnetic states asymmetrically. That is, the magnitude of the magnetic field intensity required to switch the magnetic device to one state is greater than the magnitude of the magnetic field intensity required to switch the magnetic device to the other state.

As previously described, switching offset causes the noise margin in one switching direction to be different than the noise margin in the other switching direction.

The switching offset can be at least partially a result of the demagnetization field formed between the reference layer and the sense layer of the magnetic device.

The switching offset can be at least partially a result of the Ne'el coupling field formed between the reference layer and the sense layer of the magnetic device.

The direction of the offset introduced by the demagnetization field and the direction of the offset introduced by the Ne'el coupling field can be controlled by controlling the thicknesses of the ferromagnetic pinned layers and by controlling the magnetizations of the ferromagnetic pinned layers.

## DEMAGNETIZATION FIELD

The demagnetization field, also referred to as shape anisotropy, is caused by magnetic poles at edges of the magnetic device due to the finite shape of the device. For a synthetic ferrimagnetic layer having ferromagnetic layers having opposing directions of magnetization, the net demagnetization field can be roughly equated to a vector sum of the various layers. That is, the magnetization M1 of the pinned layers can generally be estimated by summing the magnetization M1A, M1B ... M1N of each of the pinned layers.

The demagnetization field introduces an offset into the switching curve or the magnetic device. The magnitude of the offset is dependent upon the magnitude of the demagnetization field. The demagnetization offset can be calculated by performing a micro-magnetic simulation of the magnetic device geometry. The magnitude of the switching offset is influenced primarily by the size, shape and thickness of each of the magnetic layers. More precisely, the edges of each of the layer influence the magnitude of the switching offset.

## NE'EL COUPLING FIELD

Generally, Ne'el coupling can be induced in a sense layer by a pinned layer. More specifically, the Ne'el coupling can be caused by magnetic poles induced near surfaces of the sense layer and the pinned layer. Typically, the magnetic poles are created by roughness and other features of the surfaces and interfaces of the sense layer and the pinned layer.

The resulting Ne'el field is in the same direction as the magnetization of the adjacent pinned layer 326 for the embodiment of Figure 3. The Ne'el coupling introduces an offset in the switching curve of the magnetic device. The offset contribution of the Ne'el coupling is additive or subtractive depending upon the direction of the magnetization of the closest pinned layer.

The magnitude of the Ne'el coupling offset can be estimated by the following equations:

$$H_N = ((\Pi^2 h^2)/(\lambda t_s \sqrt{2}))M_s e^{-((\Pi t_b 2\sqrt{2})/\lambda)}$$

where $t_b$ is the thickness of the barrier, lambda is a roughness wavelength, h is the roughness of the interface, $t_s$ is the thickness of the sense layer, and $M_s$ is the saturation magnetization of the sense layer. The variables of this equation can be adjusted to manipulate the magnitude of the Ne'el coupling, and therefore, the switching offset introduced due to the Ne'el coupling.

The embodiment of Figure 3 can include the thickness of each of the ferromagnetic layers being formed so that the demagnetizing field between the ferromagnetic pinned layers and the sense layer substantially cancels the effects of the Ne'el magnetic field between the sense layer and the ferromagnetic pinned layers. With the embodiment configured to cancel the effects of the demagnetization field and the Nevel coupling, the switching offset of the apparatus can be minimized.

It should be noted, that other minor contributions to anisotropy of the magnetic apparatus exist which can provide minor contributions to the switching offset of the magnetic apparatus. For example, stress and magneto-crystalline anisotropy influences can cause additional switching offset. These contributions are generally small. However, their existence can be minimized by accounting for them when designing the magnetic apparatus.

An embodiment of the invention includes a plurality of ferromagnetic layers consisting of an odd number of ferromagnetic pinned layers. An embodiment that includes an odd number of ferromagnetic pinned layers will be described later.

The tunnel barrier layer 130 can more generally be designated as a spacer layer. The spacer layer can include a tunnel barrier layer 130, or the spacer layer can include a metallic layer.

An embodiment of the invention includes the ferromagnetic layer adjacent to the pinning layer being thicker than any of the other of the ferromagnetic layers. As previously described, the pinning layer 310 can fix the magnetic orientation of the pinned layers. The antiferromagnetic pinning layer 310 provides a large exchange field, which holds the magnetization of the pinned layer in one direction.

An embodiment of the invention include the magnetic moments of the ferromagnetic layers rotating directions from one ferromagnetic layer to the next, the sum of the moments being in an opposite direction as the Ne'el magnetic field between the sense layer and the ferromagnetic layers.

The reference pinned layers 322, 324, 326 and the sense layer 330 can be made of a ferromagnetic material.

If the magnetization of the sense layer 330 and the reference layer 320 of the magnetic tunnel junction sensor 300 are in the same direction, the orientation of the magnetic tunnel junction sensor can be referred to as being "parallel." If the magnetization of the sense layer 330 and the reference layer 320 of the magnetic tunnel junction sensor are in opposite directions, the orientation of the magnetic tunnel junction sensor can be referred to as being "anti-parallel." The two orientations, parallel and anti-parallel, can correspond to magnetic sensor states of low or high resistance.

The insulating tunnel barrier 340 allows quantum mechanical tunneling to occur between the pinned layer 320 (more precisely, the Nth pinned layer 326) and the sense layer 330. The tunneling is electron spin dependent, causing the resistance of the magnetic tunnel junction sensor to be a function of the relative orientations of the magnetization directions of the reference layer 320 (again, more precisely, the Nth pinned layer 326) and the sense layer 330. The presence of a magnetic field can be detected by establishing the magnetization orientations of the reference layer 320 and the sense layer 330.

The resistance of the magnetic tunnel junction sensor 300 is a first value (R) if the magnetization orientation of the magnetic tunnel junction sensor 300 is parallel and a second value (R+delta) if the magnetization orientation is anti-parallel. The invention, however, is not limited to the magnetization orientation of the two layers, or to just two layers.

The insulating tunnel barrier 340 can be made of aluminum oxide, silicon dioxide, tantalum oxide, silicon nitride, aluminum nitride, or magnesium oxide. However, other dielectrics and certain semiconductor materials may also be used for the insulating tunnel barrier 340. The thickness of the insulating tunnel barriers 340 may range from about 0.5 nanometers to about three nanometers. However, the invention is not limited to this range.

The sense layer 330 may be made of a ferromagnetic material. The reference layer can be implemented as a synthetic ferrimagnet (SF), also referred to as an artificial antiferromagnet. The synthetic ferrimagnet can include the ferromagnetic pinned layers.

The sense layer 330 of the tunnel junction sensor 300 will generally align in a direction that corresponds with a direction of an externally applied magnetic field.

As previously mentioned, the resistance across the magnetic tunnel junction sensor 300 is directly dependent upon the orientation of magnetization of the sense layers 330 with respect to the orientation of the magnetization of the reference (pinned) layer 320.

The reference (pinned) layer 320 of this embodiment includes synthetic ferrimagnetic structure pinned layers. That is, the pinned layer 320 includes a first ferromagnetic pinned layer 322, a second ferromagnetic pinned layer 324 and a third ferromagnetic pinned layer 326 (this layer is designated as the Nth pinned layer in Figure 3). The first ferromagnetic pinned layer 322 and the second ferromagnetic pinned layer 324 are separated by a non-magnetic spacer layer 323. The second ferromagnetic pinned layer 324 and the Nth ferromagnetic pinned layer 326 are separated by a non-magnetic spacer layer 325.

The ferromagnetic layers 322, 324, 326 can be made of a material such as CoFe, NiFe or Co. The spacer layers 323, 325 can be formed from magnetically non-conductive materials such as Ru, Re, Rh or Cu.

There is a strong interlayer exchange coupling between each of the ferromagnetic pinned layers 322, 324, 326. The magnitude of this coupling and its sign (that is, whether the coupling is positive or negative) is a function of the spacer layers 323, 325 thickness and material, and the ferromagnetic pinned layers 322, 324, 326 thickness and materials. For example, the coupling is negative if the magnetization direction of the first ferromagnetic pinned layer 322 is anti-parallel to the magnetization direction of the second ferromagnetic pinned layer 324. The coupling is positive if the magnetization direction of the first ferromagnetic pinned layer 322 is parallel to the magnetization direction of the second ferromagnetic pinned layer.

The coercivities of the first ferromagnetic layer 322 may be slightly different than the coercivity of the second ferromagnetic layer 324. For example, the coercivity of the first ferromagnetic layer 322 can be approximately 10 Oe, and the coercivity of the second ferromagnetic layer 324 can be approximately 50 Oe.

The coercivity of the sense layer 330 will generally be substantially less than the coercivity of the ferromagnetic pinned layers 322, 324, 326. The coercivities of the sense layer 330 and the ferromagnetic pinned layers 322, 324, 326 should be selected so that sensing of a magnetic field by the magnetic tunnel junction sensor 300 only affects the magnetic orientation of the sense layer 330, but not the magnetic orientations of the ferromagnetic pinned layers 322, 324, 326.

Since the magnetization of the first ferromtagnetic pinned layer 322 is oriented in the opposite direction as the second ferromagnetic pinned layer 324, their moments tend to cancel each other. The magnetization of the first ferromagnetic pinned layer 322 is oriented in the same direction as the Nth ferromagnetic pinned layer 326. Therefore, their moments tend to add to each other.

The thickness of the spacer layers 323, 325 may be between about .2nm and 2 nm.

Each of the ferromagnetic pinned layers 322, 324, 326 include a magnetization vectors having a magnetic intensity. Generally, the magnetic intensity of each of the ferromagnetic pinned layers 322, 324, 326 is dependent upon a thickness of the ferromagnetic pinned layers 322, 324, 326.

A vector depicted within the first ferromagnetic pinned layer 322 is longer than a vector depicted within the second ferromagnetic pinned layer 324. The lengths of the vectors represent the intensity of the magnetization of the first ferromagnetic pinned layer 322 and the intensity of the magnetization of the second ferromagnetic pinned layer 324. As depicted, the vector representing the magnetization intensity of the first ferromagnetic pinned layer 322 is greater than the vector representing the second ferromagnetic pinned layer 324.

Generally, the magnetization magnitude is dependent upon the thickness of the ferromagnetic layer. For the embodiment of Figure 3, the thickness of the first ferromagnetic pinned layer 322 is greater than the thickness of the second ferromagnetic pinned layer 324. Therefore, the magnetization of the first ferromagnetic layer 322 is greater than the magnetization of the second ferromagnetic layer 324.

Examples of potential thickness and material types of the first ferromagnetic layer 322, second ferromagnetic layers 324, third ferromagnetic layer 326 and spacer layers 323, 325 are as follows.

|  | Example 1 | Example 2 | Example 3 | Thickness (nm) |
|---|---|---|---|---|
| First Ferromagnetic Layer | CoFe | NiFe | Co | 4.0 |
| Spacer Layer (s) | Ru | Ru | Ru | .75 |
| Second Ferromagnetic Layer | CoFe | NiFe | Co | 3.0 |
| Third Ferromagnetic Layer | CoFe | NiFe | Co | 3.0 |

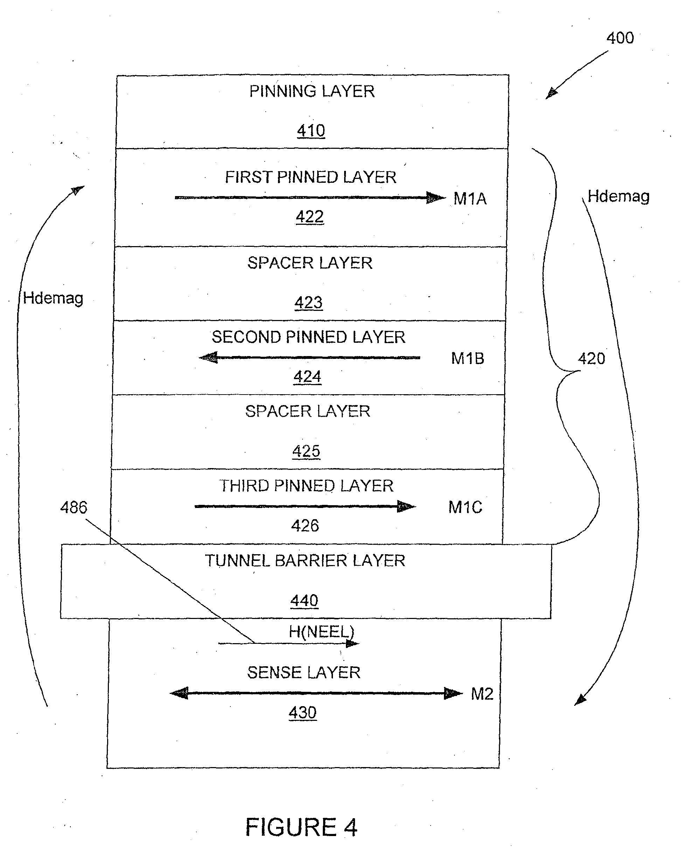

Figure 4 shows another magnetic device 400 according to an embodiment of the invention. This embodiment includes a pinned layer 420 that includes three ferromagnetic layers (pinned layers) 422, 424, 426. Each of the ferromagnetic pinned layers 422, 424, 426 includes a magnetic moment M1A, M1B, M1C.

A demagnetization field is developed between the pinned layer 420 and the sense layer 430. The direction of the demagnetization field is determined by the directions of the magnetic moments of the pinned layer 422, 424, 426. The direction of the offset introduced by the demagnetization field is dependent upon the direction of the demagnetization field. As previously described, the direction of the demagnetization field is dependent upon the magnetic moments M1A, M1B, M1C of the pinned layers 422, 424, 426. The magnetic moments are dependent upon the coercivities of the pinned layers 422, 424, 426, and the thicknesses of the pinned layers 422, 424, 426.

The odd number (more precisely, three) of pinned layers 422, 424, 426 of the magnetic tunnel junction 400 of Figure 4, provides a convenient structure for providing cancellation of the switching offset created by the demagnetization field and the Ne'el coupling field. The demagnetization field is naturally developed in a direction that is opposite of the Ne'el coupling field. As previously mentioned, it can be advantageous to have the pinned layer 422 that is proximate to the pinning layer 310 be the thickest pinned layer.

A Ne'el coupling field is developed between the third pinned layer 426 and the sense layer 430. The direction of the Ne'el coupling field is dependent upon the direction of the magnetic moment of the third ferromagnetic pinned layer 426. The magnitude of the Ne'el coupling field is dependent upon the parameters of the magnetic sensor 400 as previously described.

An insulating tunnel barrier 440 allows quantum mechanical tunneling to occur between the sense layer 430 and the third ferromagnetic pinned layer 326. The tunneling is electron spin dependent, causing the resistance of the magnetic tunnel junction device 400 to be a function of the relative orientations of the magnetization directions of the sense layer 430 and the third ferromagnetic layer 426.

The presence of a magnetic field can be detected by establishing the magnetization orientations of the sense layer 430 and the third ferromagnetic pinned layers 426. More specifically, the resistance across the magnetic tunnel junction 400 can be sensed to determine the magnetic orientation of the sense layer 430.

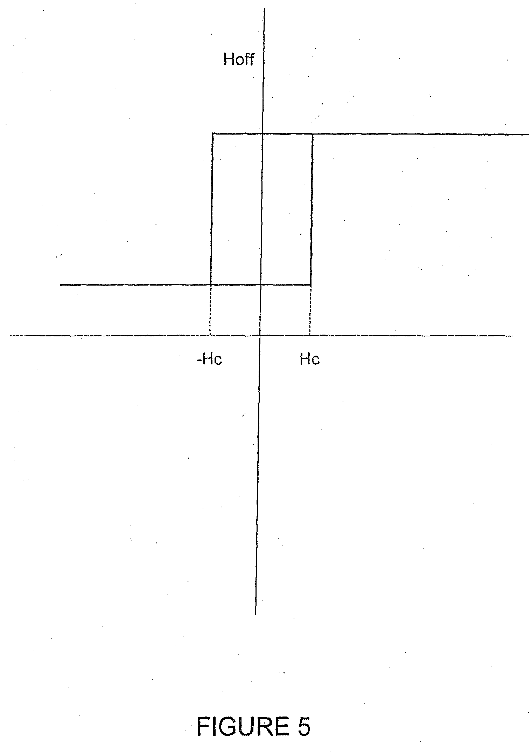

Figure 5 shows a switching response curve of a magnetic tunnel junction sensor according to an embodiment of the invention. The previously described offset Hoffs is not present in this curve because the thickness of each of the pinned layers, and the number of pinned layers, have been selected so that the switching offset caused by the demagnetization field includes a negative value of the switching offset caused by the Ne'el coupling field. The demagnetization field cancels the switching offset effects of the Ne'el coupling field.

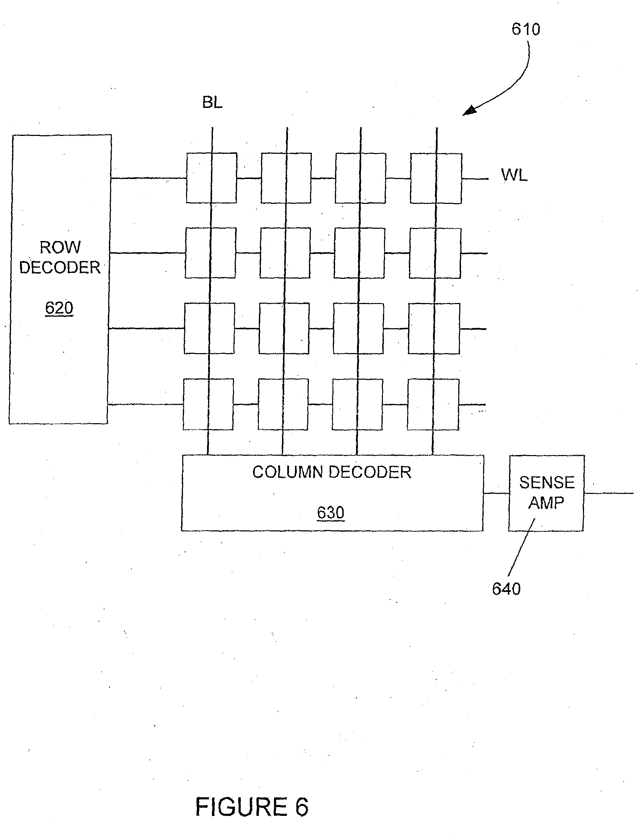

Figure 6 shows an array of MRAM memory cells according to an embodiment of the invention. This embodiment includes an array of memory (MRAM) cells 610 according to previously described embodiments. This embodiment further includes a row decoder 620, a column decoder 630 and associated sense amplifiers 640. The row decoder 620 selects a row of the array of MRAM cells 610 through a word line (WL). The column decoder 630 selects a column of the array of the MRAM cells 610 through a bit line (BL). Generally, the sense amplifiers 640 are connectable to the bit lines. The sense amplifiers 640 provide sensing of states of the memory cells.

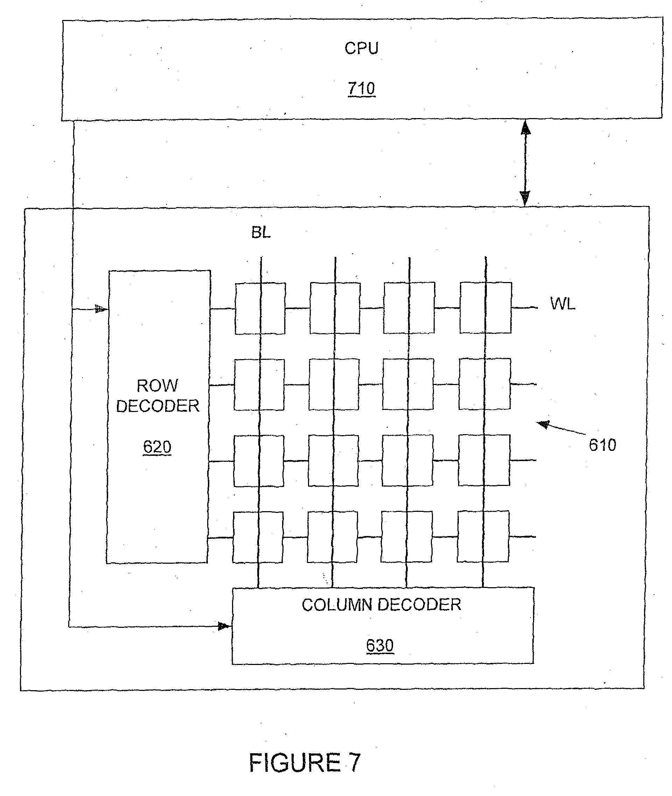

Figure 7 shows a computing system that includes an array of MRAM memory cells according to an embodiment of the invention. The computing system includes a central processing unit 710 that access an array of MRAM cell 610 as shown in Figure 6.

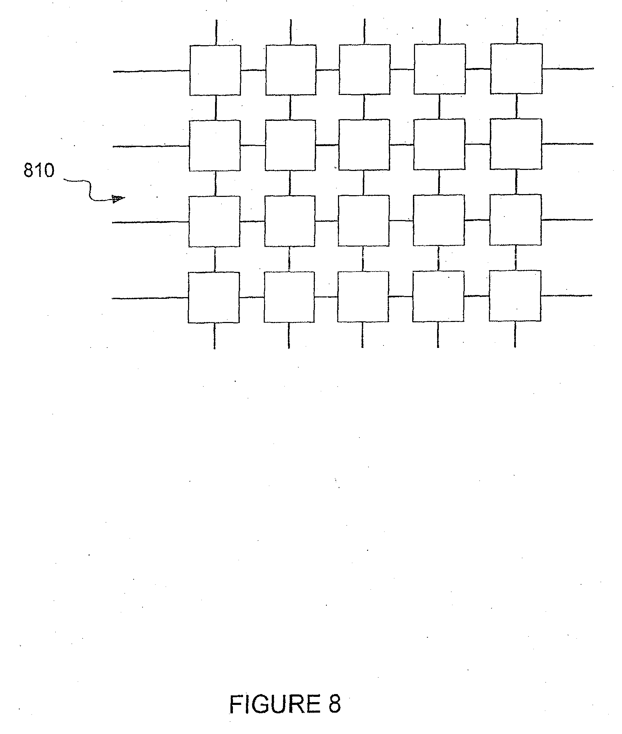

Figure 8 shows an array of magnetic sensors according to an embodiment of the invention. The array of magnetic field detection sensors 810 includes magnetic field detection sensors according to the embodiments of the invention, located according to a pattern.

The array of magnetic sensors provides for detection and sensing of magnetic fields of varied intensities. That is, detection of an external magnetic field will set the magnetic sensors to varied resistive states. By pre-exposing the array of sensors to a first magnetic field, subsequent magnetic fields will change the state of all or some of the sensors depending upon the intensity and direction of the subsequent magnetic fields.

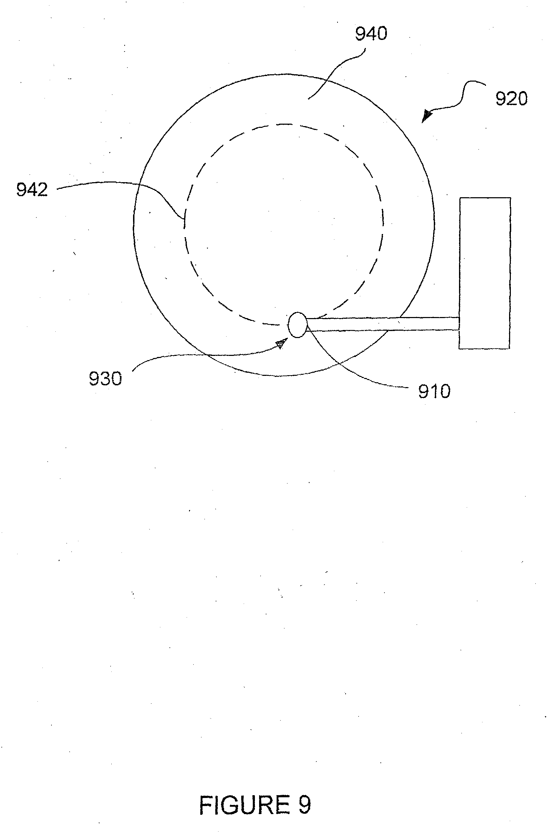

Figure 9 shows a disk drive 920 that includes a read head 910 that includes a magnetic sensor according to an embodiment of the invention. The read head 910 can include a magnetic field sensor 930 according to an embodiment of the invention. Generally, the magnetic disk drive 920 includes a magnetic disk 940 that includes information stored on a surface of the disk 942. The magnetic field detection sensor 930 detects the information stored on the surface 942 of the magnetic disk 940.

Although specific embodiments of the invention have been described and illustrated, the invention is not to be limited to the specific forms or arrangements of parts so described and illustrated. The invention is limited only by the appended claims.

**Claims**

**1.** A magnetic apparatus [300] comprising:

a pinning layer [310]; ,
a plurality of ferromagnetic layers [322, 324, 326], at least one of the ferromagnetic layers [322] being adjacent to the pinning layer [310]
a spacer layer [340] adjacent to at least one other of the ferromagnetic layers [326];
a sense layer [330] adjacent to the spacer layer [340]; wherein
a thickness of each of the ferromagnetic layers [322, 324, 326] is formed so that a Ne'el magnetic field between the sense layer [330] and the ferromagnetic layers[322, 324, 326] is in an opposite direction as a demagnetizing field between the ferromagnetic layers [322, 324, 326] and the sense layer [330].

**2.** The magnetic apparatus of claim 1, wherein the thickness of each of the ferromagnetic layers [322, 324, 326] is formed to so that the demagnetizing field between the ferromagnetic layers [322, 324, 326] and the sense layer [330] substantially cancels the effects of the Ne'el magnetic field between the sense layer [330] and the ferromagnetic layers [322, 324, 326].

3. The magnetic apparatus of claim 1, wherein the thickness of each of the ferromagnetic layers [322, 324, 326] is formed to so that the demagnetizing field between the ferromagnetic layers [322, 324, 326] and the sense layer [330] minimizes a switching offset of the magnetic field detection sensor [300].

4. The magnetic apparatus of claim 1, wherein the plurality of ferromagnetic layers [322, 324, 326] comprises an odd number of ferromagnetic layers.

5. The magnetic apparatus of claim 1, wherein the spacer layer [340] comprises a metallic layer.

6. The magnetic apparatus of claim 1, wherein the spacer layer [340] comprises a tunnel barrier layer.

7. The magnetic apparatus of claim 6, wherein a magnetic orientation of the at least one ferromagnetic layer [322] adjacent to the pinning layer [310] is in a same direction as the Ne'el magnetic field between the sense layer [330] and the ferromagnetic layers [322, 324, 326].

8. The magnetic apparatus of claim 7, wherein the at least one ferromagnetic layer [322] adjacent to the pinning layer [310] is thicker than any of the other of the plurality of ferromagnetic layers.

9. The magnetic apparatus of claim 8, wherein the plurality of ferromagnetic layers [322, 324, 326] comprises three ferromagnetic layers, each ferromagnetic layer comprising a magnetic moment.

10. The magnetic apparatus of claim 9, wherein the magnetic moments of the ferromagnetic layers [322, 324, 326] rotates directions from one ferromagnetic layer to the next, the sum of the moments being in an opposite direction as the Ne'el magnetic field between the sense layer [330] and the ferromagnetic layers.

100

PINNING LAYER

140

FIRST PINNED LAYER

112

M1A

SPACER LAYER

116

SECOND PINNED LAYER

114

M1B

110

TUNNEL BARRIER LAYER

130

SENSE LAYER

120

M2

FIGURE 1

FIGURE 2

300

PINNING LAYER

310

FIRST PINNED LAYER

$\longrightarrow$ M1A

322

Hdemag

SPACER LAYER

323

SECOND PINNED LAYER

$\longleftarrow$ M1B

324

320

SPACER LAYER

325

Hdemag

Nth PINNED LAYER

$\longrightarrow$ M1N

326

TUNNEL BARRIER LAYER

340

H(NEEL)

SENSE LAYER

330

384

386

FIGURE 3

400

| PINNING LAYER |
| :---: |
| 410 |

| FIRST PINNED LAYER |
| :---: |
| →————————————————► M1A |
| 422 |

| SPACER LAYER |
| :---: |
| 423 |

| SECOND PINNED LAYER |
| :---: |
| ◄————————————————— M1B |
| 424 |

| SPACER LAYER |
| :---: |
| 425 |

| THIRD PINNED LAYER |
| :---: |
| →————————————————► M1C |
| 426 |

| TUNNEL BARRIER LAYER |
| :---: |
| 440 |

H(NEEL)

| SENSE LAYER |
| :---: |
| ◄————————————————► M2 |
| 430 |

420

Hdemag

Hdemag

486

FIGURE 4

FIGURE 5

610

BL

ROW
DECODER

620

WL

COLUMN DECODER

630

SENSE
AMP

640

FIGURE 6

FIGURE 7

810

FIGURE 8

FIGURE 9